# EUROPEAN PATENT APPLICATION

(11) **EP 2 876 141 A1**
(43) Date of publication of application: **27.05.2015**
(21) Application number: 13193940.7
(22) Date of filing: 21.11.2013
(51) Int. Cl.: C09D 5/24, C08L 83/02, H01B 1/12, H01L 51/00

(54) **Conductive polymer composition and layer made therefrom**

(71) Applicant: Solvay SA, 1120 Bruxelles (BE)
(72) Inventor: Jung, Kisuck, 689-813 Ulsan (KR); Kim, Young-Keun, Ulju-gun Ulsan (KR); Won, Du-Hyun, 608-765 Busan (KR); Jang, Sung-Il, 607-786 Busan (KR); Park, Hyun-Woo, 617-800 Busan (KR)
(74) Representative: Mross, Stefan P.M.

(57) **Abstract**

The present invention concerns compositions comprising at least one conductive material, at least one binder, and at least one solvent, wherein the conductive material comprises at least one cation and bis(trifluoromethanesulfonyl)imide (TFSI) anion. The compositions according to the present invention can be used for forming a layer, such as a transparent electrode, an antistatic layer, and/or an electromagnetic interference shield layer particularly in a display device application.

## Description

### FIELD OF THE INVENTION

The present invention relates to a conductive composition and to a layer made from said conductive composition suitable for use as a transparent electrode, an antistatic layer, and/or an electromagnetic interference (EMI) shield layer for display device, such as liquid crystal display (LCD) device and organic light-emitting diode (OLED) device.

### BACKGROUND OF THE INVENTION

Display devices, such as liquid crystal display (LCD) devices, are used for a television, a projector, a mobile phone, a PDA, etc., and such devices usually comprise plural transparent conductive layers for various purposes, including a transparent electrode, an antistatic layer, and an electromagnetic interference (EMI) shield layer. Conventional conductive materials for the transparent conductive layer in such display device are transparent conductive oxides (TCO), such as indium tin oxide (ITO), indium zinc oxide (IZO) and antimony tin oxide (ATO). The materials are typically deposited by using sputtering. However, this process is rather complicated and costly. Also, these materials are disadvantageous because many cracks may be generated upon their formation (lack of flexibility), and indium which is the main element of ITO and IZO is a limited resource that is becoming quickly exhausted these days.

Conductive polymers have a good flexibility and are considered to be inexpensive because they can be formed by simple processing. Having these characteristics, it is believed that conductive polymer compositions are among the potential candidates to replace TCO in forming the transparent electrode, antistatic layer, and/or EMI shield layer in display devices.

One of the challenges that the conductive polymer compositions are facing is their insufficient thermal stability at high temperature, such as at least 300°C which is often required in a manufacturing process of display devices. For instance, the polyethylenedioxythiophene/polystyrenesulfonate (PEDOT/PSS), which is one of the representative conductive polymers, is disintegrated at a temperature of 200°C, and therefore, this conductive polymer cannot remain stable at high temperature process during the manufacture of display devices.

### DESCRIPTION OF THE INVENTION

The purpose of the present invention is to provide conductive compositions having particular advantageous properties, which can be suitably used for forming a transparent electrode, an antistatic layer, and/or an EMI shield layer in display devices. The compositions according to the present invention can be suitably used for forming a layer exhibiting an excellent thermal stability at high temperature, a satisfactory range of conductivity, and excellent hardness and transparency.

The present invention therefore relates to compositions comprising at least one conductive material, at least one binder, and at least one solvent, wherein the conductive material comprises at least one cation and bis(trifluoromethanesulfonyl)imide (TFSI) anion. Indeed, it has been surprisingly found that the compositions according to the present invention display superior stability at high temperature, such as at least 300°C. It has been also found that the compositions according to the present invention possess high sheet uniformity as well as excellent hardness and transparency when processed to the layer in display devices. In addition, the compositions according to the present invention can satisfy a satisfactory range of conductivity without deteriorating other properties required in certain layer in display devices.

Further, the present invention provides transparent electrodes, antistatic layers, and/or EMI shield layers, which are in particular suitable for display devices, made from the compositions according to the present invention.

### DETAILED DESCRIPTION OF THE INVENTION

In the present invention, a substrate is understood to denote in particular a solid, in particular a transparent solid on which a layer of material can be deposited using the composition according to the invention. Examples of such substrates include a glass substrate, and transparent solid polymers, for example polyethyleneterephthalate(PET), polyethylene naphthalene dicarboxylate, polycarbonate(PC), polyethersulfone(PES), polyimide(PI), cyclic olefin copolymer(COC), styrene copolymers, polyethylene, polypropylene, and any combination thereof. Preferably, the substrate is in the form of a sheet.

In the present invention, "alkyl groups" is understood to denote in particular a straight chain, branched chain, or cyclic hydrocarbon groups usually having from 1 to 20 carbon atoms, preferably having from 1 to 8 carbon atoms. Examples of alkyl groups include methyl, ethyl, propyl, isopropyl, butyl, isobutyl, sec-butyl, tert-butyl, pentyl, neopentyl, hexyl, cyclopropyl, cyclobutyl, cyclopentyl, and cyclohexyl.

In the present invention, "alkoxy groups" is understood to denote in particular a straight chain, branched chain, or cyclic hydrocarbon group usually having from 1 to 20 carbon atoms, preferably from 1 to 8 carbon atoms, singularly bonded to oxygen (Alk-O-).

In the present invention, "aryl groups" is understood to denote in particular any functional group or substituent derived from an aromatic ring. In particular, the aryl groups can have 6 to 20 carbon atoms, preferably 6 to 12 carbon atoms, in which some or all of the hydrogen atoms of the aryl group may or may not be substituted with other groups, especially alkyl groups, alkoxy groups, aryl groups, or hydroxyl groups. The aryl groups are preferably optionally substituted phenyl groups, naphthyl groups, anthryl group and phenanthryl group.

The composition according to the present invention comprises a conductive material comprising at least one cation and bis(trifluoromethanesulfonyl)imide ((CF₃SO₂)₂N⁻, "TFSI") anion. Such conductive material is believed to show an excellent thermal stability and not to be decomposed at high temperature, such as at least 300°C. Examples of TFSI-containing conductive material include:
metal salts, such as lithium TFSI, sodium TFSI, potassium TFSI, and magnesium TFSI,
ammonium salts, such as tetraethylammonium TFSI, tetrabutylammonium TFSI, tributylmethylammonium TFSI, diisopropylethylammonium TFSI, triethylammonium TFSI, acethylcholine TFSI, tris(2-(2-methoxyethoxy)ethyl)ammonium TFSI, dimethyldioctadecylammonium TFSI, benzyl-tributyl-ammonium TFSI, trimethyl(tetradecyl)ammonium TFSI, tetramethylammonium TFSI, (2-hydroxy-ethyl)-trimethyl-ammonium TFSI, carboxy-N,N,N-trimethylmethane-ammonium TFSI, bis-(2-hydroxy-ethyl)-methyl-ammonium TFSI, (2-hydroxy-ethyl)-dimethyl-octyl-ammonium TFSI, tris(2-hydroxy-ethyl)-ammonium TFSI, and trimethylhexylammonium TFSI, imidazolium salts, such as 1-butyl-3-methylimidazolium TFSI, and 1-ethyl-3-methylimidazoium TFSI,
phosphonium salts, such as tributyloctylphosphonium TFSI, tributyldodecylphosphonium TFSI, tetraphenylphosphonium TFSI, tetrabutylphosphonium TFSI, and tetrakis-hydroxymethyl-phosphonium TFSI,
pyridinium salts, such as 1-butylpyridinium TFSI, and
phenyldimethylammonium TFSI,
and guanidium salts, such as guanidium TFSI, and tetramethylguanidium TFSI, but the present invention is not limited thereto.

In the present invention, the conductive material is typically used in an amount of 0.1 to 10 wt %, preferably 1 to 8 wt %, more preferably 2 to 6 wt % relative to a total weight of the composition. By comprising the conductive material in the above range, the composition according to the present invention can exhibit good conductivity and coatability.

In the present invention, the composition comprises at least one binder. The binder in the present invention may be an organic compound, an inorganic compound, or a hybrid compound thereof. Examples of the organic binder include polyesters, such as polyethylene terephthalate, polybutylene terephthalate, and polyethylene naphthalate; polyimides, such as polyimide, and polyamideimide; polyamides, such as polyamide 6, polyamide 6,6, polyamide 12, and polyamide 11; fluororesins, such as polyvinylidene fluoride, polyvinyl fluoride, polytetrafluoroethylene, ethylenetetrafluoroethylene copolymer, and polychlorotrifluoroethylene; vinyl resins, such as polyvinyl alcohol, polyvinyl ether, polyvinyl butyral, polyvinyl acetate, and polyvinyl chloride; epoxy resin; oxetane resin; xylene resin; aramide resin; polyimide silicone; polyurethane; polyurea; melamine resin; phenol resin; polyether; organosilicones; poly(ethylene oxide)s (PEO); acrylic resin, and their copolymers.

In the present invention, the binder preferably comprises at least one thermosetting monomer and/or binder. Preferably, the binder of the composition according to the invention comprises silicone-based binder. Particularly, the thermosetting monomer and/or binder can be selected from the group consisting of trialkoxysilane, trichlorosilane, tetrachlorosilane, aminosilane-based binders, tetraalkoxysilane-based binders, and any combination thereof. Preferable examples of the thermosetting monomer and/or binder are tetraethoxysilane (TEOS), tetramethoxysilane (TMOS), TEOS-based binder, TMOS-based binder and any combination thereof. More preferably, the composition according to the present invention comprises TEOS binder.

In the present invention, the binder is typically used in an amount of 5 to 65 wt %, preferably 10 to 55 wt %, more preferably 20 to 45 wt % relative to a total weight of the composition.

In the present invention, the solvent in the composition according to the present invention is selected from the group consisting of water ; aliphatic alcohols, such as methanol, ethanol, isopropanol, butanol, n-propylalcohol, ethylene glycol, propylene glycol, butanediol, neopentyl glycol, 1,3-pentanediol, 1,4-cyclohexanedimethanol, diethyleneglycol, polyethelene glycol, polybutylene glycol, dimethylolpropane, trimethylolpropane, sorbitol, esterification products of the afore-mentioned alcohols ; aliphatic ketones, such as methyl cellosolve, propyleneglycol methylether, diacetone alcohol, ethylacetate, butylacetate, acetone and methylethylketone ; ethers such as tetrahydrofuran, dibutyl ether, mono- and polyalkylene glycol dialkyl ethers ; aliphatic carboxylic acid esters; aliphatic carboxylic acid amides ; aromatic hydrocarbons ; aliphatic hydrocarbons ; acetonitrile ; aliphatic sulfoxides ; and any combination thereof. Preferred solvents are water, isopropanol, ethylene glycol, propylene glycol methyl ether, propylene glycol methyl ether acetate, toluene, xylene, methyl ethyl ketone, dibutyl ether, butyl acetate, or any combination thereof.

In the present invention, the solvent is used in an amount of comprising the solvent in an amount of 25 to 94.9 wt %, preferably 37 to 89 wt %, more preferably 49 to 78 wt % relative to a total weight of the composition. By comprising the solvent in the above range, the composition according to the present invention can exhibit good coatability when processed to a layer.

In a further particular embodiment, the composition according to the present invention further comprises at least one additive selected from the group consisting of a conductive compound, a coupling agent, a surfactant, an inhibitor, a catalyst, an antioxidant agent, an ionic liquid, and any combination thereof.

In the present invention, the composition may optionally comprise at least one additional conductive compound. One example of the additional conductive compound includes a conductive polymer.

In the present invention, a conductive polymer is understood to denote in particular any polymeric materials that conduct electricity. In the compositions according to the invention, the conductive polymers can be, for example, dissolved or dispersed in the solvent. Preferably, the conductive polymers are dispersed in water and/or alcohol.

In the present invention, the conductive polymer may be selected from the group consisting of polyacetylene polymers, poly(p-phenylene) polymers, poly(p-phenylenesulfide) polymers, poly(p-phenylenevinylene) polymers, polyaniline polymers, polyacetylene polymers, polypyrrole polymers, polythiophene polymers, and any combination thereof. Preferably, the conductive polymer is at least one polythiophene polymers, in particular polyethylenedioxythiophene (PEDOT) polymers.

In the present invention, the PEDOT polymer is preferably doped with at least one further compound. One example of such compound for doping includes polymeric acid dopant, in particular a water soluble polymeric dopant. Examples of doped PEDOT polymers include PEDOT doped with lignosulfonic acid (LSA) (PEDOT/LSA), PEDOT doped with polyethyleneglycol (PEG) (PEDOT/PEG), PEDOT doped with polyoxometalate (POM) (PEDOT/POM), PEDOT doped with sufonated polyimide (SPI) (PEDOT/SPI), PEDOT doped with carbon materials, such as activated carbon, graphene and carbon nanotube (CNT) (activated carbon/PEDOT composite, PEDOT/graphene composite, or PEDOT/CNT composite), PEDOT doped with DMSO and CNT (PEDOT/DMSO/CNT), PEDOT doped with tosylate, PEDOT doped with chloride anion, PEDOT doped with NO₃, PEDOT doped with PSS (PEDOT:PSS), PEDOT/PSS doped with pentacene, PEDOT doped with ammonium persulfate (APS) (PEDOT/APS), and PEDOT doped with dimethyl sulfoxide (DMSO) (PEDOT/DMSO), but the present invention is not limited thereto. The PEDOT polymer is preferably doped with a polymer having at least one sulfonic acid, such as polystyrenesulfonate (PSS).

In the preferred embodiment of the present invention, the conductive polymer comprises at least one polythiophene polymer, preferably polyethylenedioxythiophene (PEDOT) polymer, doped with at least one water soluble polymeric dopant, preferably polystyrenesulfonate (PSS). In this embodiment, the ratio of PEDOT and PSS is preferably 5:95 to 50:50 by weight.

In the present invention, a coupling agent is understood to function to aid an adhesion to a substrate when applied to the substrate. Such coupling agent can be selected, for example, from the group consisting of ammonia, chlorosilane, monomeric aminosilane, γ-glycidoxypropyltrimethoxysilane, γ-glycidoxypropyltriethyoxysilane, γ-glycidoxypropylethyldimethoxysilane, γ-glycidoxypropylethyldiethoxysilane, vinyltrimethoxysilane, vinyltriethoxysilane, β-glycidoxypropyltrimethoxysilane, N-β-aminoethyl-γ-aminopropyltrimethoxysilane, N-β-aminoethyl-γ-aminopropyltriethoxysilane, γ-mercaptopropyltrimethoxysilane, γ-chloropropyltrimethoxysilane, γ-acryloxypropyldimethoxysilane and any combination thereof. Preferred examples of the coupling agent are chlorosilane, monomeric amino silane, vinyltrimethoxysilane, and vinyltriethoxysilane.

In the present invention, a surfactant is understood to denote in particular a material that lowers the surface tension of a liquid, the interfacial tension between two liquids, or that between a liquid and a solid. The surfactant in the present invention preferably has a hydrophile lipophile balance (HLB) of 8 to 16, preferably 10 to 13. Preferred examples of the surfactant include BYK^{®} surfactants (obtainable from BYK Additives & Instruments), such as BYK^{®}-307, alkanesulfonates, betaines, alkylethoxylates, ethersulfates, and any combination thereof. More preferably, the surfactants are BYK^{®}-307, alkanesulfonates, and alkylethoxylates.

In the present invention, an inhibitor can be optionally added to the composition in order to keep the adequate extent of the polymerization. The examples of the inhibitor include hydroquinone, dialkylacetylenedicarboxylate, dimethylacetylenedicarboxylate, diethylenedicarboxylate, dibutylacetylenedicarboxylate, metylbutylacetylenedicarboxylate, methylethylacetylenedicarboxylate, and any combination thereof. Preferred inhibitors are hydroquinone, dialkylacetylenedicarboxylate, and dimethylacetylenedicarboxylate.

In the present invention, a catalyst can be used to accelerate a formation of binder from the respective monomer in the composition according to the present invention. Amines, organic or inorganic acids, metals or metal salts, peroxides, or any combination thereof can be used as the catalyst in the present invention. The non-limiting examples of the amines include ammonia, methylamine, dimethylamine, trimethylamine, ethylamine, diethylamine,triethylamine, n-propylamine, isopropylamine, di-n-propylamine, di-isopropylamine, tri-n-propylamine, n-butylamine, isobutylamine, di-n-butylamine, di-isobutylamine, tri-n-butylamine, n-pentylamine, di-n-pentylamine, tri-n-pentylamine, dicyclohexylamine, aniline, 2,4-dimethylpyridine, 4,4-trimethylenebis(1-methylpiperidine), 1,4-di-azabicyclo [2,2,2] octane, N,N-dimethylpiperazine, cis-2,6-dimethylpiperazine, trans-2,5-dimethylpiperazine, 4,4-methylenebis(cyclohexylamine), stearylamine, 1,3-di-(4-piperidyl)propane, N,N-dimethylpropanolamine, N,N- dimethylhexanolamine, N,N-dimethyloctanolamine, N,N-diethylethanolamine, 1-piperidineethanol, 4-piperidinol, and any combination thereof. The non-limiting examples of organic or inorganic acids include acetic acid, propionic acid, butyric acid, valeric acid, caproic acid, maleic acid, stearic acid, hydrochloric acid, nitric acid, sulfuric acid, phosphoric acid, chloric acid, hypochlorous acid, and any combination thereof. The non-limiting examples of metals and metal salts include palladium, palladium acetate, palladium acetylacetonate, silver, silver acetylacetonate, platinum, platinum acetylacetonate, ruthenium, ruthenium acetylacetonate, ruthenium carbonyls, gold, copper, copper acetylacetonate, aluminum acetylacetonate, aluminum tris(ethylacetoacetate), and any combination thereof. The non-limiting examples of peroxides include hydrogen peroxide, metal chlorides, organometallic compounds, such as ferrocenes and zirconocenes, and any combination thereof. Preferred examples of the catalyst in the present invention are 4,4-methylenebis(cyclohexylamine), acetic acid, hydrochloric acid, platinum, platinum acetylacetonate, hydrogen peroxide, and dicumyl peroxide.

In the present invention, an ionic liquid is understood to denote, in particular, a salt which comprises an electrochemically neutral pair of cations and anions in the liquid state whose melting point is usually below 100°C. The ionic liquid preferably comprises a cation comprising an organic moiety, in particular an asymmetric organic moiety. Examples of the cations of the ionic liquid include :
ammonium or tetraalkyl ammonium cations, such as tetramethyl ammonium,
tetrabutyl ammonium, tetrahexyl ammonium, butyltrimethyl ammonium, and
methyltrioctyl ammonium cations,
guanidinium cations, such as N,N,N',N'-tetrahexyl-N",N"- dimethylguanidinium cations,
imidazolium cations, more typically, imidazolium cations that are substituted with from 1 to 3, more typically 2 to 3, alkyl, hydroxyalkyl, and/or aryl substituents per boron atom, such as 1,3-dimethyl-imidazolium, 1-benzyl-3-methyl-imidazolium, 1-butyl-3-methyl-imidazolium, 1-ethyl-3-methyl-imidazolium, 1-hexyl-3-methyl-imidazolium, 1-methyl-3-propyl-imidazolium, 1-methyl-3-octyl-imidazolium, 1-methyl-3-tetradecyl-imidazolium, 1-methyl-3-phenyl-imidazolium, 1,2,3-trimethyl-imidazolium, 1,2-methyl-3-octyl-imidazolium, 1-butyl-2,3-dimethyl-imidazolium, 1-hexyl-2,3-methyl-imidazolium, and 1-(2-hydroxyethyl)-2,3-dimethyl-imidazolium cations, morpholinium cations, such as N-methyl-morpholinium and N-ethyl-morpholinium cations,
phosphonium cations, such as tetrabutyl phosphonium and tributylmethyl phosphonium cations,
piperidinium cations, such as 1-butyl-1-methyl-piperidinium and 1-methyl-1-propyl-piperidinium cations,
pyradazinium cations,
pyrazinium cations, such as 1-ethyl-4-methyl-pyrazinium, and 1-octyl-4-propyl-pyrazinium cations,
pyrazolium cations, such as 1-ethyl-2,3,5-pyrazolinium cations,
pyridinium cations, such as N-butyl-pyridinium, and N-hexyl- pyridinium cations,
pyrimidinium cations, such as 1-hexyl-3-propyl-pyrimidinium, and 1-ethyl-3-methyl-pyrimidinium cations,
pyrrolidinium cations, such as 1-butyl-1-methyl-pyrrolidinium and 1-methyl-1-propyl-pyrrolidinium cations,
pyrrolium cations, such as 1,1-dimethyl-pyrrolium, and 1-methyl-1-pentyl-pyrrolium cations,
pyrrolinium cations,
sulfonium cations, such as trimethyl sulfonium cations,
thiazolium cations,
oxazolium cations,
triazolium cations, and
any combination thereof.
In the present invention, the ionic liquid preferably comprises at least one compound having an imidazolium cation. More preferably, the ionic liquid comprises at least one imidazolium cation selected from the group consisting of 1,3-dimethyl-imidazolium, 1-benzyl-3-methyl- imidazolium, 1-butyl-3-methyl-imidazolium, 1-ethyl-3-methyl-imidazolium, 1-hexyl-3-methyl-imidazolium, 1-methyl-3-propyl-imidazolium, 1-methyl-3-octyl-imidazolium, 1-methyl-3-tetradecyl-imidazolium, 1-methyl-3-phenyl-imidazolium, 1,2,3-trimethyl-imidazolium, 1,2-methyl-3-octyl-imidazolium, 1-butyl-2,3-dimethyl-imidazolium, 1-hexyl-2,3-methyl-imidazolium, and 1-(2-hydroxyethyl)-2,3-dimethyl-imidazolium cations.

*Examples of the anion suitable for the ionic liquid include:*
borate anions, such as tetrafluoroborate, tetracyanoborate, tetrakis-(p-(dimethyl(1H, 1H, 2H, 2H-perfluorooctyl)silyl)phenyl)borate, alkyltrifluoroborate, perfluoroalkyltrifluoroborate, and alkenyltrifluoroborate anions,
carbonate anions, such as hydrogen carbonate and methylcarbonate anions,
carboxylate anions, such as salicylate, thiosalicylate, L-lactate, acetate, trifluroacetate, and formate anions,
chlorate anions,
cyanate anions, such as thiocyanate, dicyanamide, and tricyanomethane anions,
halide anions, such as fluoride, chloride, bromide, and iodide anions,
imide anions, such as imide and bis(fluoromethylsulfonyl)imide anions, nitrate anions,
phosphate anions, such as dihydrogen phosphate, hexafluorophosphate,
di(trifluromethyl)tetrafluorophosphate, tris(trifluoromethyl)trifluorophosphate,
tris(perfluoroalkyl)trifluorophosphate, tetra(trifluoromethyl)difluorophosphate,
penta(trifluoromethyl)fluorphosphate, and hexa(trifluoromethyl)phosphate anions,
sulfate and sulfonate anions, such as trifluoromethanesulfonate, hydrogen sulfate, tosylate, (C₁-C₁₂)alkylsulfate, and (C₁-C₁₂)alkylsulfonate anions,
perfluoroalkyl beta-diketonate anions, such as 6,6,7,7,8,8,8- heptafluoro-2,2-dimethyl-3,5-octanedionate, 1,1,1,5,5,5-hexafluoro-2,4-pentanedionate, and 4,4,4-trifluoro-1-(2-thienyl)-1,3-butanedionate anions,
fluorohydrogenate anions, such as poly(hydrogen fluoride) fluoride anions, fluorometallate anions, such as oxopentafluorotungstan (VI) anions, and any combination thereof.

In the present invention, examples of the ionic liquid include 1-ethyl-3-methyl-imidazolium tetrachloroaluminate, 1-butyl-3-methyl-imidazolium tetrachloroaluminate, 1-ethyl-3-methyl-imidazolium acetate, 1-butyl-3-methyl-imidazolium acetate, 1-ethyl-3-methyl-imidazolium ethylsulfate, 1-butyl-3-methyl-imidazolium methylsulfate, 1-ethyl-3-methyl-imidazolium thiocyanate, 1-butyl-3-methyl-imidazolium thiocyanate, 1-ethyl-3-methyl-imidazolium bis(trifluoromethanesulfonyl)imide, 1-ethyl-3-methyl-imidazolium tetracyanoborate, 1-butyl-1-methyl-pyrrolidinium dicyanamide, 1-ethyl-3-methyl-imidazolium tetrafluoroborate, 1-ethyl-3-methyl-imidazolium trifluroacetate, 1-ethyl-3-methyl-imidazolium bis(fluoromethylsulfonyl)imide, and mixtures thereof, but the present invention is not limited thereto. The ionic liquid in the present invention preferably comprises 1-ethyl-3-methyl-imidazolium tetracyanoborate.

In the present invention, examples of the antioxidant agent include citric acid, gallate esters, tocopherols, other phenol-based antioxidants, amine-based antioxidants, phosphorous-based antioxidants, sulfur-based antioxidants, sugars, and vitamins.

In an especially preferred embodiment, the composition according to the present invention comprises at least one TFSI-containing conductive material, and at least one silicone-based binder in a mixed solvent comprising water and at least one alcohol.

In a further particular embodiment of the present invention, the composition comprises at least one TFSI-containing conductive material, PEDOT/PSS polymer, and at least one silicone-based binder in a mixed solvent comprising water and at least one alcohol.

Another aspect of the present invention concerns a layer comprising a mixture of at least one conductive material, and at least one binder, obtainable by using the composition according to the present invention, wherein the conductive material at least comprises bis(trifluoromethanesulfonyl)imide (TFSI) moiety. As to the details of the conductive material, and the binder in this aspect, the above corresponding explanations can be referred to. The layer according to the present invention can be used as a conductive layer in electronic devices. Preferably, the layer of the present invention is a transparent conductive layer. More preferably, such layer functions as a transparent electrode, an antistatic layer, and/or an electromagnetic interference (EMI) shield layer in display device.

The transparent electrode in the present invention is understood to denote any type of electrode used in electronic devices, in particular display devices. Examples thereof include common electrode, pixel electrode, electrodes included in thin-film transistor (TFT), such as gate electrode, scanning electrode, and data (signal) electrode, and optional electrodes, such as segment electrode, and chevron electrode.

It has been surprisingly found that the layer according to the present invention exhibits an excellent thermal stability even at high temperature of at least 200°C, preferably at least 230°C, more preferably at least 300°C, still more preferably at least 350°C and less than 400°C while showing a good flexibility, a satisfactory range of conductivity, and great hardness and transparency.

The layer can be formed by applying the compositions of the present invention on the substrate, in particular on a surface of glass substrate. Such application can be brought about for example using laser etching, wetting, such as dipping, printing, such as gravure printing and inkjet printing, coating, such as spin coating, bar coating, slit coating, spray coating, roll coating, and spreading, or deposition. The thickness of the layer on the substrate is preferably from 100 to 10,000 Å, more preferably 3,000 to 4,000 Å. After applying the composition on the substrate, the layer can be formed for example by curing. Typical temperatures for the curing are from 25 to 150°C, preferably 100 to 150°C. Typical curing time is from 5 to 30 min, preferably 10 to 30 min.

A further aspect of the present invention concerns an electronic device at least comprising the layer according to the present invention. Representative examples of the electronic device in the present invention include display devices, such as LCD and OLED.

A still further aspect of the present invention concerns a process of manufacturing a layer comprising at least one TFSI-containing conductive material, and at least one binder, which is obtainable by using the composition according to the present invention.

The process for the manufacture of the layer preferably comprises (a) evenly spreading the composition according to the present invention on a surface of a substrate and (b) curing the composition spread on the surface.

Thusly-formed layer according to the present invention has generally a sheet resistance of 10³ to 10¹² Ω/·. If the layer is intended as the antistatic layer according to the present invention, it generally has a sheet resistance of 10⁷ to 10¹² Ω/·. Alternatively, the antistatic layer according to the present invention has a sheet resistance of 10³ to 10¹¹ Ω/·, preferably 10⁴ to 10⁸ Ω/·. In case the layer is intended as the EMI shield, it generally has a sheet resistance of 10³ to 10⁶ Ω/·. Also, the layer has generally a pencil hardness of equal to or more than 7 H, which sufficiently satisfies the requirement as a transparent conductive layer in display device, especially LCD device.

While preferred embodiments of this invention have been shown and described, modifications thereof can be made by one skilled in the art without departing from the spirit or teaching of this invention. The embodiments and examples described herein are exemplary only and are not limiting. Many variations and modifications of systems and methods are possible and are within the scope of the invention. Accordingly, the scope of protection is not limited to the embodiments described herein, but is only limited by the claims that follow, the scope of which shall include all equivalents of the subject matter of the claims.

The following examples illustrate the invention in further detail without however limiting it.

### Examples

### Example 1: Preparation of Conductive Compositions

### Example 1-1 : Conductive solution according to the present invention

5.0 wt% of LiTFSI, 42.7 wt% of polysiloxane binder, 0.18 wt% acid catalyst, and remainder of isopropanol and water are incorporated to stirrer, and those components are mixed under stirring, thus obtaining the conductive solution.

### Example 1-2 : Comparative conductive solution 1

5.0 wt% of PEDOT:PSS, 42.7 wt% of polysiloxane binder, 0.18 wt% acid catalyst, and remainder of isopropanol and water are incorporated to stirrer, and those components are mixed under stirring, thus obtaining the comparative conductive solution 1.

### Example 2: Evaluation of coating films made of Conductive Solutions

The conductive solutions according to Examples 1-1 and 1-2 are supplied to a spin coater, and coated with rotation speed at 300 rpm for 3 seconds, 1000 rpm for 15 seconds, and 300 rpm for 3 seconds at a room temperature. The formed coating films using the conductive polymer solutions are treated in dry oven at a temperature of about 140°C for 10 min.

A sheet resistance, transmittance, surface hardness, thermal stability, and sheet uniformity of the coating film are evaluated, and summarized as below:
- Sheet resistance : measured using 2-point probe
- Transmittance : measured using UV-VIS spectrometer at 550 nm
- Surface hardness: measured using pencil hardness test method
- Thermal stability : temperature test performed at temperature of 350°C
- Sheet uniformity : deviation of resistance values at different points of the coating film were measured

**Table 1 : Evaluation Results**

| | Example 1-1 | Example 1-2 |
|---|---|---|
| Resistance(Ω/·) | 10⁶∼10⁹ | 10⁶∼10⁹ |
| Transmittance | Above 99% | 98% |
| Hardness | 7H | 7H |
| Thermal stability | Excellent | Bad |
| Sheet uniformity | Good | Good |

## Claims

1. A composition comprising at least one conductive material, at least one binder, and at least one solvent, wherein the conductive material comprises at least one cation and bis(trifluoromethanesulfonyl)imide (TFSI) anion.

2. The composition according to claim 1, wherein the conductive material comprises at least one TFSI-containing compound selected from the group consisting of metal salt with TFSI, ammonium TFSI, imidazolium TFSI, phosphonium TFSI, pyridinium TFSI, guanidium TFSI, and any combination thereof.

3. The composition according to claim 1 or 2, wherein the binder comprises at least one thermosetting monomer and/or binder, in particular at least one thermosetting silicone-based monomer and/or binder selected from the group consisting of trialkoxysilane, trichlorosilane, tetrachlorosilane, aminosilane-based binders, tetraalkoxysilane-based binders, and any combination thereof, especially tetraethoxysilane (TEOS), tetramethoxysilane (TMOS), TEOS-based binder, TMOS-based binder, and any combination thereof.

4. The composition according to any one of claims 1 to 3, wherein the solvent is selected from the group consisting of water ; aliphatic alcohols, such as methanol, ethanol, isopropanol, butanol, n-propylalcohol, ethylene glycol, propylene glycol, butanediol, neopentyl glycol, 1,3-pentanediol, 1,4-cyclohexanedimethanol, diethyleneglycol, polyethelene glycol, polybutylene glycol, dimethylolpropane, trimethylolpropane, sorbitol, esterification products of the afore-mentioned alcohols ; aliphatic ketones, such as methyl cellosolve, propyleneglycol methylether, diacetone alcohol, ethylacetate, butylacetate, acetone and methylethylketone ; ethers such as tetrahydrofuran, dibutyl ether, mono- and polyalkylene glycol dialkyl ethers ; aliphatic carboxylic acid esters; aliphatic carboxylic acid amides ; aromatic hydrocarbons ; aliphatic hydrocarbons ; acetonitrile ; aliphatic sulfoxides ; and any combination thereof.

5. The composition according to any one of claims 1 to 4, comprising the conductive material in an amount of 0.1 to 10 wt %, preferably 1 to 8 wt %, more preferably 2 to 6 wt % relative to a total weight of the composition.

6. The composition according to any one of claims 1 to 5, comprising the binder in an amount of 5 to 65 wt %, preferably 10 to 55 wt %, more preferably 20 to 45 wt % relative to a total weight of the composition.

7. The composition according to any one of claims 1 to 6, further comprising at least one additive selected from the group consisting of a conductive compound, a coupling agent, a surfactant, an inhibitor, a catalyst, an antioxidant, and any combination thereof.

8. The composition according to claim 7, wherein the conductive compound comprises at least one PEDOT/PSS polymer.

9. A layer comprising a mixture of at least one conductive material, and at least one binder, obtainable by using the composition according to any one of claims 1 to 8, wherein the conductive material at least comprises bis(trifluoromethanesulfonyl)imide (TFSI) moiety.

10. The layer according to claim 9, which functions as a transparent electrode, an antistatic layer, and/or an electromagnetic interference (EMI) shield layer.

11. The layer according to claim 9 or 10, which is thermally stable at a temperature of at least 200°C, preferably at least 230°C, more preferably at least 300°C, still more preferably at least 350°C, and less than 400°C.

12. A process for manufacturing the layer according to any one of claims 9 to 11, which comprises (a) evenly spreading the composition according to any one of claims 1 to 8 on a surface of a substrate and (b) curing the composition spread on the surface.

13. An electronic device at least comprising the layer according to any one of claims 9 to 11.
